# EUROPEAN PATENT APPLICATION

(11) **EP 1 914 558 A2**
(43) Date of publication of application: **23.04.2008**
(21) Application number: 07118473.3
(22) Date of filing: 15.10.2007
(51) Int. Cl.: G01R 31/28, H01G 4/35

(54) **Method to test transparent - to - test capacitors**

(30) Priority: 17.10.2006 US 582069
(71) Applicant: Delphi Technologies, Inc., Troy, Michigan 48007 (US)
(72) Inventor: Nair, Balakrishnan V., 760 283, Yishun Ave 6 (SG)
(74) Representative: Denton, Michael John

(57) **Abstract**

An inexpensive process for verifying that a capacitor, which would be difficult to detect using in-circuit testing techniques if the capacitor were a conventional two-terminal capacitor, has been properly installed on a circuit board involves incorporating into the circuit a feedthrough capacitor having at least two internally electrically connected terminals, and testing for electrical continuity between points on the circuit electrically connected to the internally connected terminals of the feedthrough capacitor.

## Description

### Technical Field

This invention relates to in-circuit testing of electrical packages, and more particularly to in-circuit testing to detect the presence of capacitors in an electrical circuit.

### Background of the Invention

Electrical packages generally comprise electronic components mounted on a circuit board, such as a printed circuit board. Typical electronic components that are mounted on the circuit board include integrated circuits (e.g., flip chips and/or leaded chips), resistors, inductors, capacitors, etc.

It is not uncommon for an electrical component to be occasionally omitted during production of an electronic assembly. For example, the pick and place machine can drop the part during the placement process. Or the reel that contains the component has a missing part. In this sense, an electronic component can be physically absent on the circuit board.

Typically, after the PCB (printed circuit board) is assembled, it is tested prior to final cover assembly to confirm that the components are present and/or functioning properly in the circuitry at the PCB assembly level. Various techniques have been employed to verify the presence of the electronic components and/or functionality of the electronic components in the PCB assembly. A preferred technique that is typically used to confirm that components are present and functioning properly is in-circuit testing. Typically, during in-circuit testing, a plurality of electrical probes are placed in electrical contact with individual electronic components through test points in the PCB assembly, groups of electrical components, or entire circuits. The probes are electrically connected to a test apparatus that applies an electrical signal to the individual electrical components, groups of electrical components, or entire circuits, and measures an output signal.

Unfortunately, it is sometimes very difficult, impractical, or nearly impossible to effectively test for the presence and proper functioning of certain electrical components in a particular circuit. For example, in circuits having a large bulk capacitance in combination with a plurality of very low value bypass capacitors arranged in parallel, it is often very difficult, impractical, or nearly impossible to detect the presence or functionality of the very low value capacitors using in-circuit testing. These difficult to test components are known as transparent-to-test components. These transparent-to-test components, while not easily detectable or susceptible to analysis using in-circuit testing, can be critical to performance of the electrical package. Accordingly, other methods have been developed for detecting the presence of these components in a circuit. Visual inspection of transparent-to-test components have been employed to verify the presence of these components to a circuit in an electrical package. However, visual inspection is an expensive, labor intensive operation, which workers often find tedious, and which does not always identify problem components. Automated techniques for verifying that a transparent-to-test component has been properly placed in the circuitry of an electrical package include image processing systems and/or laser detection systems. While these automated systems are substantially less labor intensive and more accurate than visual inspection techniques, these automated component detection systems are very expensive, and require more floor space in the manufacturing/testing facility.

Another technique that has been proposed, for example to detect transparent-to-test capacitors, involves use of a split pad technique. In this technique, a component (such as a capacitor) having two terminals is connected to four separate contact pads on the circuit board, with each terminal on the electronic component being connected to two separate (or split) contact pads. One contact pad connected to each terminal electrically connects the electrical component to circuitry on the electrical package, while the other contact electrically connected to each of the terminals is electrically connected to test pads on the circuit board for in-circuit testing of the component. This technology has the advantage of allowing the component to be tested for operational functionality, in addition to detecting whether the component is present in the circuit. However, split pad technology is often impractical because it can present printed circuit board manufacturing issues, assembly stack up issues, and long-term reliability issues.

### Summary of the Invention

A process for testing for the presence of a transparent-to-test capacitor utilizing in-circuit testing is provided. The process involves utilizing a feedthrough capacitor, rather than a conventional two-terminal capacitor, at a location in an electrical circuit where it is difficult, impractical and/or nearly impossible to detect the presence of a conventional two-terminal capacitor using standard in-circuit testing techniques. The feedthrough capacitor includes at least two internally electrically connected terminals and at least a third terminal, with capacitance being provided between either of the internally electrically connected terminals and the third terminal. The process further involves determining whether there is electrical continuity between circuit traces electrically connected to one of the two internally electrically connected terminals of the feedthrough capacitor and the other circuit trace connected to the other internally electrically connected terminal. The feedthrough capacitor has four solder pads on the PCB. Two of the pads used to solder each end of the internally electrically connected terminals. During in-circuit testing the continuity measured between the two pads meant for the internally electrically connected terminals only if the feedthrough capacitor is soldered on to the board properly. The invention simplifies and reduces the cost associated with verifying the presence of transparent-to-test capacitors.

These and other features, advantages and objects of the present invention will be further understood and appreciated by those skilled in the art by reference to the following specification, claims and appended drawings.

### Brief Description of the Drawings

The present invention will now be described, by way of example, with reference to the accompanying drawings, in which:
FIG. 1 is a perspective view of a feedthrough capacitor that may be used in accordance with the process of this invention.
FIG. 2 is a graphical symbol for the feedthrough capacitor shown in FIG. 1.
FIG. 3 is a block/circuit diagram illustrating a circuit having a transparent-to-test capacitor. In this example component 28 and 30 is transparent-to-test because of the low capacitance value. In-Circuit tester has limitation to measure capacitance below certain value (say 15 pF).
FIG. 4 is block/circuit diagram illustrating another electric circuit having a transparent-to-test capacitor. In this example component 48 and 46 are connected in parallel. So if one of the capacitor has very high value compared to the other capacitor, the lower value capacitor become transparent-to-test part.
FIG. 5 is a block/circuit diagram illustrating a circuit that is equivalent to the circuit shown in FIG. 3, which in accordance with the process of this invention uses a feedthrough capacitor in place of a conventional two-terminal capacitor.
FIG. 6 is a block/circuit diagram illustrating a circuit that is equivalent to the circuit shown in FIG. 4, which in accordance with the process of this invention uses a feedthrough capacitor in place of a conventional two-terminal capacitor which is identified as transparent-to-test.

### Description of the Preferred Embodiments

In accordance with the process of this invention, difficulties associated with detecting the presence of a conventional two-terminal capacitor that is transparent to standard in-circuit testing techniques are overcome by replacing a conventional two-terminal capacitor with a feedthrough capacitor having internally electrically connected terminals, and testing for electrical continuity between a test point electrically connected to one of the internally connected terminals of the feedthrough capacitor, and a test point electrically connected to the other internally connected terminal of the capacitor. This is a very simple test to determine whether there is electrical continuity or an open circuit, thereby indicating whether the capacitor is properly positioned and electrically connected or completely missing or improperly positioned. The process of this invention is easily and inexpensively automated using conventional component indexing and in-circuit testing techniques, eliminating complicated pad designs such as the split-pad technique discussed above, and avoids the need for expensive equipment and/or high labor costs.

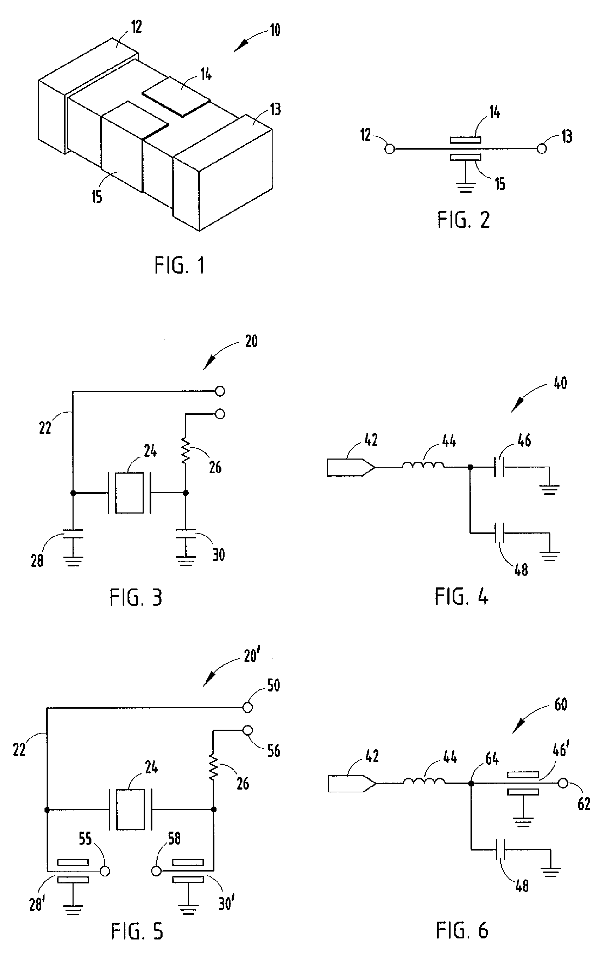

In FIG. 1, there is shown a perspective view of a feedthrough capacitor 10 having terminals 12, 13, 14 and 15. Terminals 12 and 13 are internally connected, i.e., an electrical conductor passes through the dielectric core material of the capacitor electrically connecting terminals 12 and 13. Electrical capacitance is present between either of the internally electrically connected terminals 12, 13 and either of the remaining terminals 14, 15. Feedthrough capacitor 10 is represented symbolically in FIG. 2.

FIG. 3 is a block/circuit diagram illustrating an electric circuit 20 having electrically conductive pathways or circuit traces 22 connecting the various components as illustrated, including an oscillator 24 (e.g. 8 MHz), a resistor 26, and capacitors 28 and 30 to each of the crystal terminals. In such an arrangement, capacitors 28 and 30, depending on the values of their capacitance, can be extremely difficult, if not impossible to detect using standard in-circuit testing techniques.

FIG. 4 is a block circuit diagram illustrating an electronic circuit 40 having a power input 42, a resistor 44 (e.g., 10 microhenrys), and two capacitors 46 and 48, which are in parallel. In this illustrated circuit arrangement, when one of the capacitors has a much higher capacitance than the other capacitor, the capacitor with the lower capacitance cannot be tested using standard in-circuit testing techniques. For example, with a 3.3 volt 2.52 MHz power source, a 10 microhenry inductor 44, and a 10 microfarad (+/- 10/%) capacitor 48, a 0.047 microfarad capacitor (+/- 10%) 46 could not be tested using standard in-circuit testing techniques.

FIG. 5 shows an equivalent circuit 20' to that shown in FIG. 3, in which the conventional two-terminal capacitors 28, 30 are replaced with feedthrough capacitors 28' and 30'. With this arrangement, the presence of capacitor 28' in the circuit can be verified by determining that there is electrical continuity between, for example, test points 50 and 55. Similarly, the proper placement of capacitor 30' in the circuit can be verified by determining that there is electrical continuity between test points 56 and 58.

FIG. 6 shows a circuit 60 that is equivalent to circuit 40 shown in FIG. 4. However, rather than using a conventional 0.047 microfarad capacitor 46 having two-terminals as shown in FIG. 4, circuit 60 utilizes a feedthrough capacitor 46', which allows verification of proper placement and electrical connection of capacitor 46' by simply testing for electrical continuity between, for example, test points 62 and 64.

It will be understood by those who practice the invention and those skilled in the art that various modifications and improvements may be made to the invention without departing from the spirit of the disclosed concept. The scope of protection afforded is to be determined by the claims and by the breadth of interpretation allowed by law.

## Claims

1. A process for verifying the proper placement and electrical connection of a capacitor on a circuit board, comprising:
providing a circuit board having mounted thereon two or more electrically connected components to define an electrical circuit, the components including at least one feedthrough capacitor having at least two internally electrically connected terminals and at least a third terminal, capacitance being present between either of the internally electrically connected terminals and the third terminal; and
testing for electrical continuity between a point on the circuit electrically connected to a first of the two internally electrically connected terminals and a point on the circuit that is electrically connected to a second of the two internally electrically connected terminals of the feedthrough capacitor.
